(19) Europäisches Patentamt / European Patent Office / Office européen des brevets

(11) **EP 2 300 877 B1**

(12) **EUROPÄISCHE PATENTSCHRIFT**

(45) Veröffentlichungstag und Bekanntmachung des Hinweises auf die Patenterteilung:
**19.06.2013 Patentblatt 2013/25**

(21) Anmeldenummer: **09776995.4**

(22) Anmeldetag: **07.07.2009**

(51) Int Cl.:
*G03F 7/20* (2006.01)     *H01L 41/09* (2006.01)

(86) Internationale Anmeldenummer:
**PCT/EP2009/004892**

(87) Internationale Veröffentlichungsnummer:
**WO 2010/009807 (28.01.2010 Gazette 2010/04)**

(54) **AKTUATOR UND PROJEKTIONSBELICHTUNGSANLAGE**

ACTUATOR AND PROJECTION EXPOSURE SYSTEM

ACTIONNEUR ET INSTALLATION D'EXPOSITION PAR PROJECTION

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **22.07.2008 DE 102008034285**

(43) Veröffentlichungstag der Anmeldung:
**30.03.2011 Patentblatt 2011/13**

(73) Patentinhaber: **Carl Zeiss SMT GmbH**
**73447 Oberkochen (DE)**

(72) Erfinder:
• **WEBER, Ulrich**
**89075 Ulm (DE)**

• **HEMBACHER, Stefan**
**86399 Bobingen (DE)**
• **SCHÖPPACH, Armin**
**73431 Aalen (DE)**

(74) Vertreter: **Raunecker, Klaus Peter**
**Lorenz & Kollegen**
**Patentanwälte Partnerschaftsgesellschaft**
**Alte Ulmer Straße 2**
**89522 Heidenheim (DE)**

(56) Entgegenhaltungen:
**DE-A1- 1 933 205     JP-A- 9 093 961**
**JP-A- 55 076 559**

**Beschreibung**

Die Erfindung betrifft einen Aktuator zur hochpräzisen Positionierung bzw. Manipulation von Komponenten, insbesondere von optischen Elementen oder anderen Funktionselementen in Projektionsbelichtungsanlagen für die Halbleiterlithographie sowie ein Verfahren zum Betrieb eines derartigen Aktuators. Dabei ist der Begriff "Aktuator" als Synonym zu den ebenfalls verwendeten Begriffen "Aktor" und "Stellglied" zu sehen.

Eine Positionierung bzw. Manipulation im Nanometerbereich ist für die oben genannten Komponenten regelmäßig erforderlich, um die Gesamtfunktionalität des übergeordneten Systems gewährleisten zu können. Hierbei ist es oftmals notwendig, die Position der positionierten/manipulierten Komponente oder deren Ausrichtung im Raum mit einer hochauflösenden und damit kostenintensiven und gegebenenfalls auch störanfälligen Mess- und Regelelektronik zu überwachen.

Die Erfahrungen mit Systemen aus dem Stand der Technik haben gezeigt, dass die Genauigkeit der Positionierung bzw. Manipulation dabei vorwiegend nicht durch die Aktuatorik selbst, sondern durch die Genauigkeit der Positionsmessung bestimmt wird. Mit anderen Worten können die Aktuatoren kleinere Schrittweiten auflösen als durch die Positionsmessung ermittelt werden kann.

Den Aktuatoren nach dem Stand der Technik ist jedoch das Problem gemeinsam, dass sich die Schrittweite des Antriebs in Abhängigkeit von der Last, die am Läufer des Aktuators wirkt, ändert. Dies führt dazu, dass die Abtriebsbewegung unkalkulierbar wird, so dass diese mit einem Messsystem überwacht werden muss. Hinzu kommt noch, dass sich über längere Verfahrwege des Aktuators die genannte Abweichung der Schrittweite aufsummiert.

Die beschriebene Problematik soll nachfolgend anhand des in der deutschen Offenlegungsschrift DE 102 25 266 A1 beschriebenen Piezoaktuators erläutert werden. In der genannten Schrift ist ein Aktuator beschrieben, bei dem der Aktuatorläufer (also der bewegte Teil des Aktuators, der in der Regel auf die zu manipulierende bzw. zu positionierende Komponente wirkt) über ein oder mehrere Vorschubelemente ("Füße") vorangetrieben wird, die senkrecht zum Läufer stehen. Dabei bewegen sich die Vorschubelemente senkrecht zu ihrer eigenen Längsrichtung in Läuferrichtung.

Da ein derartiger Fuß auch in Richtung der Läuferbewegung, also in Richtung der Wirkrichtung des Aktuators eine gewisse Nachgiebigkeit zeigt, hängt die Schrittweite, die durch den Fuß erbracht wird, einerseits von der Kraft ab, die der Fuß selbst aufbringen kann (Vorschubkraft) andererseits von der Kraft, gegen die der Fuß anarbeitet bzw. von der Kraft, die am Läufer des Aktuators Zug oder Druck ausübt.

Damit wird durch eine definierte Vorschubkraft der Fuß um einen definierten Betrag ausgelenkt, allerdings wird diese Auslenkung aufgrund der Nachgiebigkeit des Fußes durch eine zweite Auslenkung, die aus der Last am Läufer herrührt, überlagert.

Wirkt beispielsweise eine Kraft am Läufer in Vorschubrichtung, wird die Schrittweite größer als die Nominalschrittweite, das ist die Schrittweite, auf die der Aktuator ausgelegt ist. Wirkt umgekehrt eine Kraft am Läufer entgegen der Wirkrichtung, wird die Schrittweite kleiner als die Nominalschrittweite.

In Fällen, in denen sich während des Verfahrens des Aktuators die Last am Läufer ändert, ändert sich mit ihr auch die Schrittweite. Deswegen muss die Schrittweite mit einem zusätzlichen hochpräzisen Wegsensor überprüft werden, was jedoch aus Bauraum-oder Handhabungsgründen nicht immer erwünscht oder möglich ist.

Eine alternative Art hochauflösender Schrittantriebe sind Inertialantriebe. Bei diesen Antrieben schiebt ein Vorschubelement, beispielsweise eine Piezokeramik, über einen Reibkontakt den Läufer langsam in eine Richtung. Dabei muss die Last am Läufer und die Beschleunigungskraft des Läufers kleiner als die im Reibkontakt übertragbare Reibkraft sein. Anschließend wird das Vorschubelement ruckartig zurückgezogen, wobei die notwendige Beschleunigungskraft des Läufers für die schnelle Rückwärtsbewegung größer ist als die im Reibkontakt übertragbare Reibkraft. Damit bleibt der Läufer stehen, während das Vorschubelement gegenüber dem Läufer zurückrutscht. Derartige Antriebe weisen jedoch den Nachteil auf, dass sie nur eine geringe Kraft ausüben können, da die Kraft am Läufer zusammen mit der Beschleunigungskraft (Trägheitskraft) des Läufers die übertragbare Reibkraft bei der Vorwärtsbewegung nicht übersteigen darf.

Da zudem der Läufer beim ruckartigen Zurückziehen des Vorschubelementes nicht festgehalten wird, kann der Läufer in diesem Moment durch eine externe Kraft am Läufer "dejustiert" werden.

Deutsche Offenlegungsschrift DE 1 933 205 A offenbart einen Mikroschritt-Motor mit geradliniger Bewegung seines Antriebsorgans mittels eines zwischen zwei steuerbaren Festhalteeinrichtungen angeordneten Vorschubelements. Unter Einfluss einer elektrischen Steuergröße wird dadurch eine Längenänderung des Vorschubelements bewirkt, wodurch die Bewegung des Antriebsorgans hervorgebracht wird.

Es ist die Aufgabe der vorliegenden Erfindung, einen Aktuator anzugeben, der bei hoher ausübbarer Kraft eine weitgehend lastunabhängige präzise Positionierung bzw. Manipulation von aktuierten Komponenten gestattet.

Diese Aufgabe wird gelöst durch den Aktuator mit den in Patentanspruch 1 aufgeführten Merkmalen sowie durch das Verfahren mit den in Anspruch 22 aufgeführten Merkmalen. Die Unteransprüche beziehen sich auf vorteilhafte Varianten und Ausführungsbeispiele der Erfindung.

Der erfindungsgemäße Aktuator mit einer Wirkrichtung weist ein Gehäuse und ein gegenüber dem Gehäuse in Wirkrichtung des Aktuators bewegbaren Läufer auf, wobei der Aktuator eine Vorschubeinheit aufweist, die mindestens zeitweise mit dem Läufer in Verbindung steht. Die Vorschubeinheit zeigt mindestens eine Deformationseinheit sowie mindestens einen Deformator zur Verformung der Deformationseinheit; der mindestens eine Deformator ist geeignet, die Deformationseinheit mit einer zur Wirkrichtung des Aktuators senkrechten Vektor- insbesondere Kraftkomponente derart zu verformen, dass sich die Gesamtlänge der Deformationseinheit in Wirkrichtung als Ergebnis der Verformung ändert.

Das Gehäuse kann aus mindestens zwei Gehäuseteilen besteht, die über die Deformationseinheit mit einander verbunden sind und die jeweils mindestens eine Arretiereinheit aufweisen können, mit welcher der Läufer an dem jeweiligen Gehäuseteil arretiert werden kann.

Die Deformationseinheit kann mindestens eine Blattfeder aufweisen, insbesondere kann sie als Federpaar aus zwei einander gegenüberliegenden Blattfedern ausgebildet sein, wobei mindestens zwei Deformatoren derart an dem Federpaar angeordnet sein können, dass sie von außen her die Federn aufeinander zu biegen können.

Der Läufer kann einen ersten und einen zweiten Teilläufer aufweisen, wobei die beiden Teilläufer über die als Teil des Läufers ausgebildete Deformationseinheit verbunden sind.

Dabei können mindestens zwei Arretiereinheiten vorhanden sein, die jeweils einen der Teilläufer gegenüber dem Gehäuse arretieren können.

Zur Hemmung der Bewegung des Läufers in Wirkrichtung des Aktuators kann der Aktuator Dämpfungselemente aufweisen.

In einer vorteilhaften Variante der Erfindung kann die Deformationseinheit mindestens ein druckbeaufschlagbares Rohr aufweisen.

Alternativ kann die Deformationseinheit mindestens ein temperierbares Bimetall, eine magnetische Biegefeder, eine Drahtfeder oder auch eine Kombination unterschiedlicher Biegefedern mit unterschiedlichem Querschnitt und/oder unterschiedlicher Länge aufweisen.

Der Deformator kann ein Piezoelement, insbesondere einen Piezostack, eine elektromagnetische Spule, einen Hydraulik- oder Pneumatikzylinder oder auch einen pneumatischen Balg aufweisen. Daneben kann der Deformator als Kondensator mit Kondensatorplatten ausgebildet sein, dessen elektrisches Feld zu einer Deformation von zwischen den Kondensatorplatten angeordneten Biegeelementen führt.

Ein mögliches Verfahren zum Betrieb eines erfindungsgemäßen Aktuators mit einem Läufer, der eine Deformationseinheit aufweist, umfasst die nachfolgend dargestellten Schritte:

- Fixieren des Läufers durch eine in Bewegungsrichtung des Läufers gesehen vor der Deformationseinheit befindliche erste Arretiereinheit
- Lösen einer in Bewegungsrichtung des Läufers gesehen hinter der Deformationseinheit befindlichen zweiten Arretiereinheit von dem Läufer
- Deformation der Deformationseinheit durch den Deformator
- Fixierung des Läufers durch die zweite Arretiereinheit
- Lösen der ersten Arretiereinheit
- Lösen des Deformators von der Deformationseinheit

Dabei können die einzelnen Verfahrensschritte, insbesondere die beiden zuletzt aufgeführten, von der oben dargestellten Reihenfolge abweichen.

Weitere vorteilhafte Ausgestaltungen und Weiterbildungen der Erfindung ergeben sich aus den Unteransprüchen und das dem nachfolgend anhand der Zeichnung prinzipmäßig beschriebenen Ausführungsbeispielen.

Figur 1          zeigt in den Teilfiguren 1a bis 1d eine erste Ausführungsform der Erfindung;

Figur 2          zeigt in den Teilfiguren 2a bis 2d eine Variante der Erfindung, bei der ein praktisch unbegrenzter Verfahrweg des Aktuators möglich ist;

Figur 3          zeigt eine Anordnung, bei der Dämpfungselemente zum Einsatz kommen;

Figur 4          zeigt in den Teilfiguren 4a bis 4e eine Möglichkeit zum ruckfreien Verfahren des Aktuators;

Figur 5          zeigt eine Verwendung des Aktuators zum hochgenauen Einstellen von Wegen;

Figuren 6 bis 19   zeigen Möglichkeiten, Deformatoren und Deformationselemente unter Anwendung verschiedener technischer Prinzipien zu realisieren;

Figur 20	zeigt als schematische Darstellung das mechanische Grundprinzip der Erfindung;

Figur 21	zeigt einen z-Manipulator für eine Projektionsbelichtungsanlage für die Halbleiterlithographie, in der ein erfindungsgemäßer Aktuator zur Anwendung kommt;

Figur 22	zeigt eine Projektionsbelichtungsanlage für die Halbleiterlithographie, in der ein erfindungsgemäßer Aktuator bzw. ein Manipulator, wie er in Figur 21 dargestellt ist, zur Anwendung kommt.

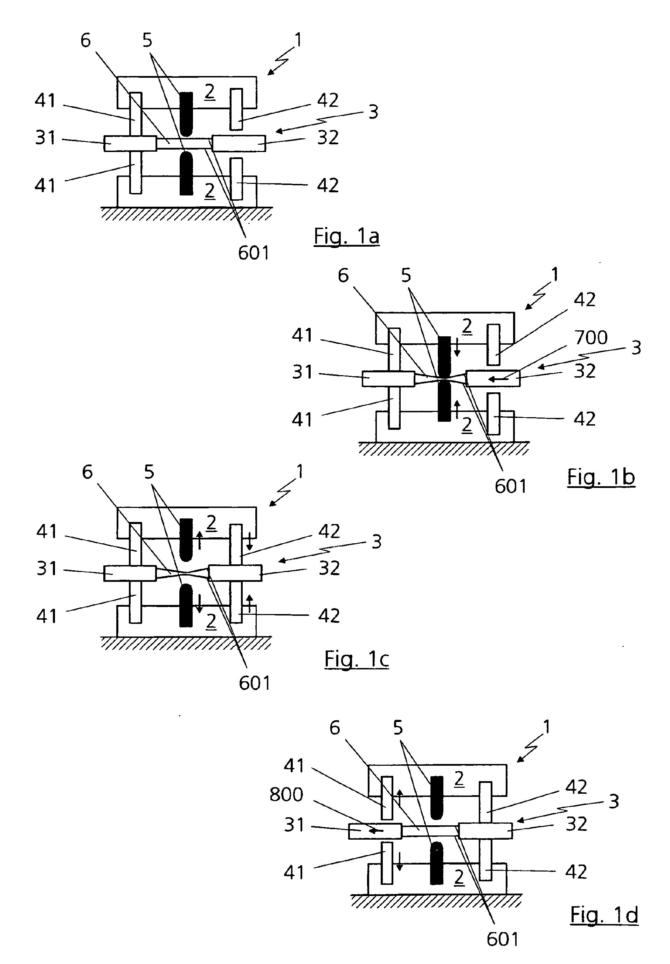

Figur 1 zeigt eine erste Ausführungsform der Erfindung. Der Aktuator 1 besteht in dem Figur 1 gezeigten Beispiel aus dem Gehäuse 2 sowie dem darin angeordneten Läufer 3, der mindestens zeitweise von den Arretiereinheiten 41 bzw. 42 gehalten wird. Dabei müssen die Arretiereinheiten 41 bzw. 42 nicht zwangsläufig den Läufer 3 mittels mechanischen Kontakts halten; auch eine berührungslose Arretierung, bspw. durch elektrische oder magnetische Kräfte kann zur Anwendung kommen. Ferner sind in dem Gehäuse 2 die Deformatoren 5 angeordnet, die auf die Deformationseinheit 6 wirken. Die Deformationseinheit 6 ist in dem gezeigten Beispiel so ausgeführt, dass sie aus den beiden Blattfedern 601 besteht, die die beiden Teilläufer 31 bzw. 32 des Läufers 3 miteinander verbinden. Anhand der Figurenteile 1a bis 1c wird die Wirkungsweise des erfindungsgemäßen Aktuators 1 nachfolgend erläutert.

Figur 1a zeigt den ersten Schritt zum Verfahren des Läufers 3 gegenüber dem Gehäuse 2. Der Läufer 3 ist an seinem Teilläufer 31 in dem in Figur 1a gezeigten Verfahrensschritt mittels der Arretiereinheiten 41 fixiert; der rechte Teilläufer 32 frei beweglich; die Arretiereinheiten 42 sind geöffnet. Auch die Deformatoren 5, die senkrecht zur Wirkrichtung des Aktuators 1 und damit senkrecht zu der Bewegungsrichtung des Läufers 3 wirken, sind in das Gehäuse 2 zurückgefahren.

In dem in Figur 1b dargestellten zweiten Verfahrensschritt sind die beiden Deformatoren 5 ausgefahren und deformieren die Blattfedern 601, die aneinander gegenüberliegend angeordnet sind, aufeinander zu, so dass sich als Resultat der Durchbiegung der beiden Blattfedern 601 eine Verkürzung des Läufers 3 in Richtung des Pfeiles 700 ergibt. Mit anderen Worten wandert der rechte Teilläufer 32 nach links, in Richtung des linken Teilläufers 31.

In dem in Figur 1c dargestellten Verfahrensschritt wird der rechte Teilläufer 32 durch die zugehörigen Arretiereinheiten 42 arretiert, während die Deformatoren 5 wieder in das Gehäuse 2 eingezogen werden und die Blattfedern 601 freigeben, allerdings sind die Arretiereinheiten 41, durch die der linke Teilläufer 31 gehaltert wird, in diesem Zustand noch geschlossen, so dass sich im Ergebnis noch keine Bewegung des linken Teilläufers 31 ergibt.

Erst in dem in Figur 1d dargestellten vierten Verfahrensschritt werden die linken Arretiereinheiten 41 geöffnet und geben den linken Teilläufer 31 frei, der im Ergebnis eine Bewegung nach links in Richtung des Pfeiles 800 vollzieht. Damit ist ein vollständiger Zyklus zur Bewegung des Läufers 3 gegenüber dem Gehäuse 2 des Aktuators 1 abgeschlossen.

Die in Figur 1a bis 1d dargestellten Schritte können prinzipiell solange wiederholt werden, wie es die geometrischen Gegebenheiten des Aktuators 1, insbesondere die Ausdehnung der Blattfedern 601 in Wirkrichtung des Aktuators 1, zulassen. Ferner ist es möglich, den in Figur 1 dargestellten Aktuator 1 sowohl in Zugals auch in Druckrichtung zu betreiben, d. h. entweder den rechten Teilläufer 32 oder den linken Teilläufer 31 mit einem zu bewegenden Element zu verbinden.

Aus Figur 1 wird erkennbar, dass die Geometrie des Aktuators 1 und insbesondere die Tatsache, dass die Blattfedern 601 senkrecht zur Wirkrichtung des Aktuators (also senkrecht zu der Richtung der Pfeile 700 bzw. 800) betätigt werden, die vorteilhafte Wirkung hat, dass sich einerseits eine hohe Untersetzung und andererseits eine hohe Steifigkeit des Aktuators 1 in Wirkrichtung ergibt.

Die maximale Kraft, die durch den in Figur 1 dargestellten Aktuator 1 aufgebracht werden kann, entspricht dabei bei einem Druckbetrieb des Aktuators 1 der eulerschen Knickkraft der Blattfedern 601 bei einem Betrieb des Aktuators auf Zug besteht diese Einschränkung nicht, sondern die maximal aufzubringende Zugkraft wird im wesentlichen von der durch Deformatoren 5 aufbringbaren Kraft sowie durch den E-Modul der Blattfedern 601 begrenzt.

Die sehr hohe Untersetzung ermöglicht auch die Einhaltung einer konstanten definierten Schrittweite unabhängig von der Last am Läufer 3, indem die relativ große Deformation der Blattfedern 601 senkrecht zur Wirkrichtung durch eine Deformationsbegrenzung genau definiert wird, wodurch auch die Schrittweite in Wirkrichtung durch die hohe Untersetzung sehr genau bestimmt wird. In den Fig. 1a bis 1d kann diese Deformationsbegrenzung beispielsweise dadurch verwirklicht werden, dass die Blattfedern 601 so weit durchgebogen werden, bis sie aufeinanderstoßen.

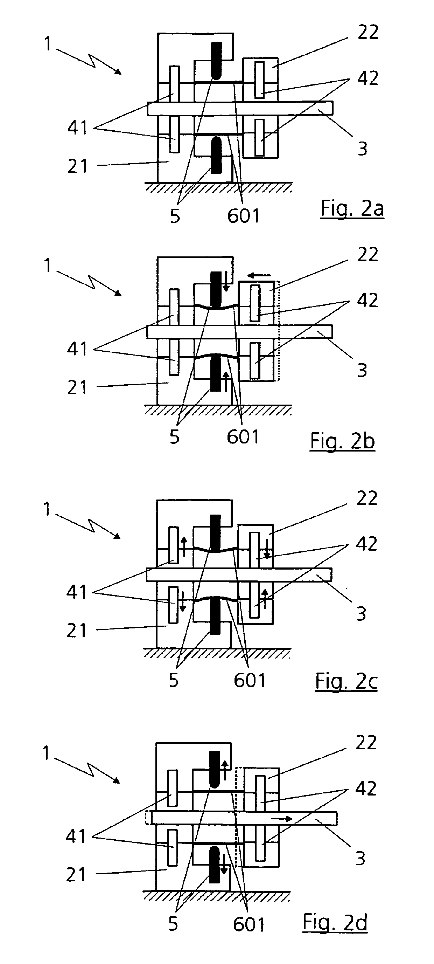

Figur 2 zeigt eine Variante der Erfindung, bei der der Verfahrweg des Läufers 3 praktisch unbegrenzt ist. In der in Figur 2 dargestellten Variante ist das Gehäuse des Aktuators 1 zweiteilig aus den beiden Gehäuseteilen 21 bzw. 22 ausgeführt, die über die Blattfedern 601 miteinander in Verbindung stehen. Im ersten Gehäuseteil 21 sind dabei die ersten Arretiereinheiten 41 angeordnet, während im zweiten Gehäuseteil 22 die zweiten Arretiereinheiten 42 angeordnet sind. Ebenfalls im ersten Gehäuseteil 21 befinden sich die Deformatoren 5, die im Wesentlichen analog zu der in Figur 1 dargestellten Variante auf die Blattfedern 601 einwirken.

In dem in Figur 2a dargestellten ersten Verfahrensschritt sind die linken Arretiereinheiten 41 geschlossen und halten den Läufer 3, während die rechten Arretiereinheiten 42 geöffnet sind damit den rechten Teil des Läufers 3 freigeben. Die Blattfedern 601 sind entspannt, da die Deformatoren 5 in den ersten Gehäuseteil 21 eingezogen sind.

In dem in Figur 2b dargestellten zweiten Verfahrensschritt fahren die Deformatoren 5 aus dem ersten Gehäuseteil 21 aus und deformieren die Blattfedern 601 in der bereits aus Figur 1 bekannten Weise, wodurch sich der rechte Gehäuseteil 22 mit den geöffneten Arretiereinheiten 42 in Richtung des ersten Gehäuseteils 21 entlang dem Läufer 3 bewegt. Nachfolgend (in Figur 2c dargestellt) werden die rechten Arretiereinheiten 42 geschlossen, wodurch der Läufer 3 arretiert wird und die linken Arretiereinheiten 41 werden geöffnet. Im letzten Verfahrensschritt, der in Figur 2b dargestellt ist, werden die Deformatoren 5 in den ersten Gehäuseteil 21 zurückgezogen, wodurch sich die Blattfedern 601 entspannen. Dadurch, dass in dem in Figur 2 gezeigten Beispiel die Deformationseinheit 6, also die Blattfedern 601 mit den Gehäuseteilen 21 und 22 und nicht mit dem Läufer 3 verbunden sind, wird es möglich, dem Läufer 3 gegenüber den Gehäuseteilen 21 bzw. 22 praktisch über eine unbegrenzte Strecke zu verschieben.

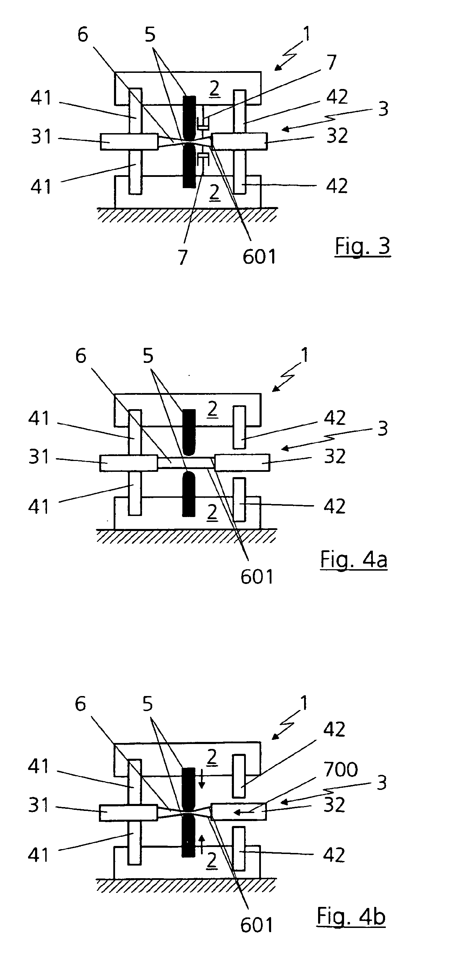

Insbesondere in dem in Figur 1 dargestellten Ausführungsbeispiel der Erfindung kann es vorkommen, dass beim Lösen der Arretiereinheiten 41 ein schlagartiges Entspannen der Blattfedern 601 erfolgt und damit ein unerwünschter Impuls auf den Aktuator 1 ausgeübt wird. Diese Problematik lässt sich, wie in Figur 3 dargestellt, dadurch abmildern bzw. umgehen, dass die Entspannung der Blattfedern 601 bzw. die damit einhergehende Bewegung des Läufers 3 durch den Einsatz der Dämpfer 7 gehemmt wird, wodurch sich der oben beschriebene Impuls weitgehend vermeiden lässt. Die Dämpfer 7 können dabei beispielsweise als hydraulische oder auch als elektromagnetische Dämpfer, welche als Tauchspulen ausgeführt sind, ausgebildet sein.

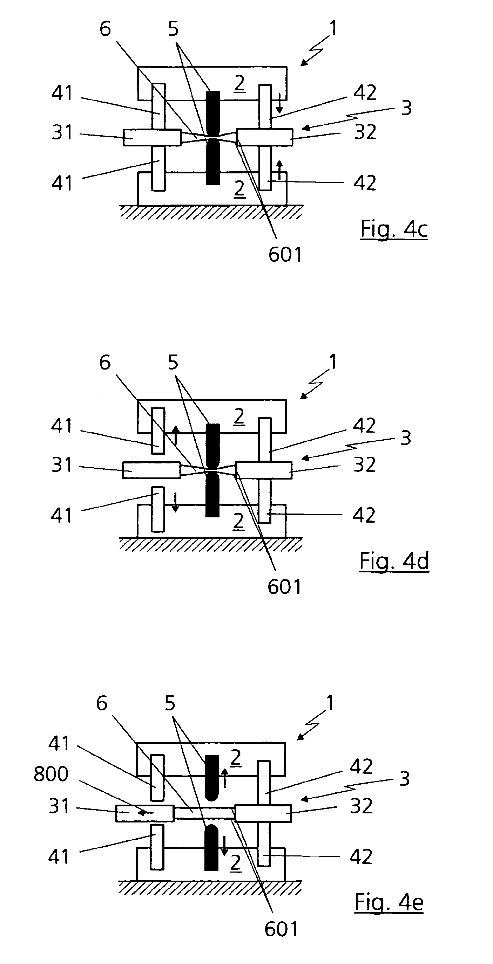

Figur 4 zeigt in den Teilfiguren 4a bis 4e eine alternative Möglichkeit, den Impuls beim Entspannen der Blattfedern 601 zu verhindern. Im wesentlichen entspricht die Darstellung in Figur 4 der Darstellung in Figur 1; der Unterschied besteht darin, dass die Blattfedern 601, wie in Figur 4d bzw. Figur 4e gezeigt, erst dann entspannt werden, wenn die Deformationseinheit 41 den linken Läuferteil 31 freigegeben hat. Der linke Läuferteil 31 kann dann kontrolliert durch ein kontrolliertes Zurückfahren der Deformatoren 5 in das Gehäuse 2 ausgefahren werden.

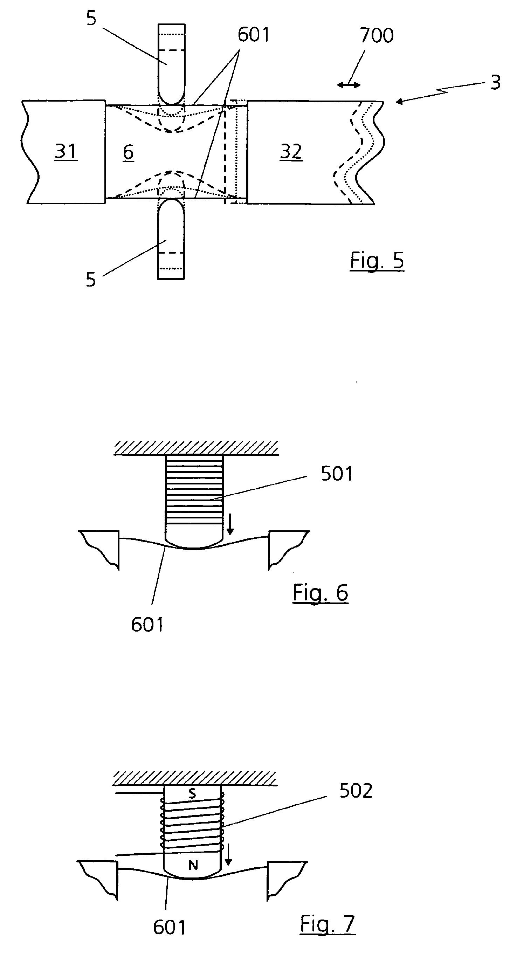

Die hohe Untersetzung, die durch den erfindungsgemäßen Aktuator 1 realisiert wird, ermöglicht es auch, durch ein dosiertes Betätigen der Deformatoren 5, wie in Figur 5 dargestellt, eine Feinverstellung des Läufers 3 bzw. des Aktuators 1 zu erreichen. Ein vergleichsweise langer Weg der Deformatoren 5 verursacht aufgrund der geometrischen Gegebenheiten der Erfindung einen ausgesprochen kurzen Verfahrweg des Läufers 3. Es genügt also, bei Kenntnis der geometrischen Gegebenheiten und Materialkonstanten den Verfahrweg der Deformatoren 5 zu messen und dann auf den damit korrespondierenden Verfahrweg des Läufers 3 zurückzuschließen. Diese Variante der Erfindung ermöglicht es insbesondere, ein Messsystem geringer Auflösung zur Überwachung des Verfahrweges einzusetzen, da lediglich der vergleichsweise große Verfahrweg der Deformatoren 5 gemessen werden muss. Die Umrechnung in den resultierenden, erheblich geringeren Verfahrweg des Läufers 3 ist deswegen wenig fehlerbehaftet, weil zum einen der erfindungsgemäße Aktuator eine hohe Untersetzung realisiert und zum anderen der Aktuator in seiner Wirkrichtung ausgesprochen steif aufgebaut ist, so dass die Deformation des Läufers 3 in Wirkrichtung nur in einem sehr geringen Maß von der durch die zu aktuierende Komponente aufgebrachten Gegenkraft abhängt.

Wenn sich der gesamte zurückgelegte Weg des Läufers 3 aus mehreren Einzelschritten zusammensetzt, kann dieser Weg aus der Summe der Deformatorenbewegungen unter Berücksichtigung der genau bekannten Untersetzung zwischen Deformator 5 und Läufer 3 ermittelt werden. Dadurch ist es nicht mehr notwendig, ein hochgenaues Meßsystem für den gesamten Läuferverfahrweg zur Verfügung zu stellen, wie es gegenwärtig notwendig ist. Mit dem Aktuator gemäß der Erfindung ist es hierfür ausreichend, ein Meßsystem für den Deformator 5 zu verwenden, das nur den geringen Verfahrbereich des Deformators 5 abdeckt, und wegen der hohen Untersetzung keine so hohe Auflösung benötigt wie die bisher hierfür verwendeten Meßsysteme.

In den Figuren 6 bis 19 sind verschiedene Möglichkeiten zur Ausführung der Deformationseinheit bzw. der Deformatoren skizziert.

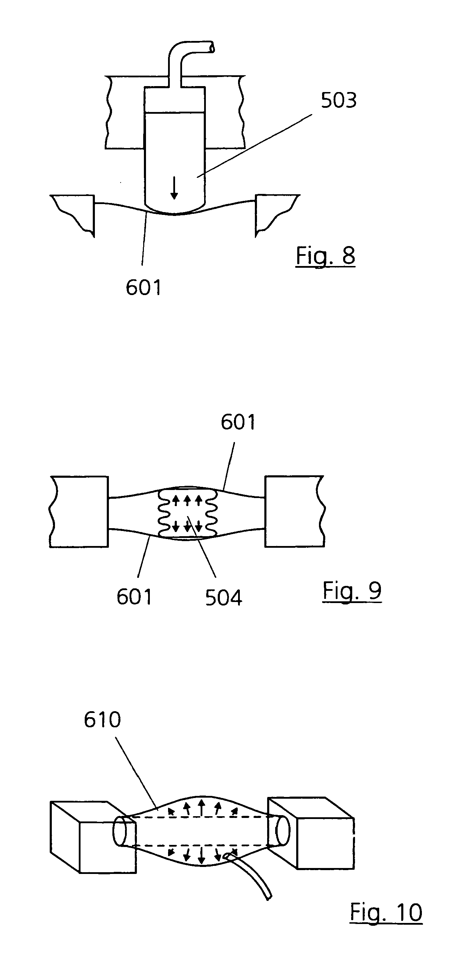

So sind in den Figuren 6 bis 9 die Deformationseinheiten 6 als Blattfedern 601 (jeweils nur eine Blattfeder dargestellt) realisiert. Der Deformator ist in Figur 6 als Piezoelement 501, in Figur 7 als elektromagnetische Spule 502 mit Eisenkern, in Figur 8 als Hydraulikzylinder mit zugehörigem Hydraulikstempel 503, sowie in Figur 9 als pneumatischer Balg 504 zwischen den beiden Blattfedern 601 ausgeführt. In Figur 10 ist die Deformationseinheit als dünnwandiges Rohr 610 realisiert, das von dem Rohrinneren her mit einem gewissen Druck beaufschlagt werden kann. Das Rohr 610 zeigt dabei eine Doppelfunktionalität als Balg bzw. Biegefeder.

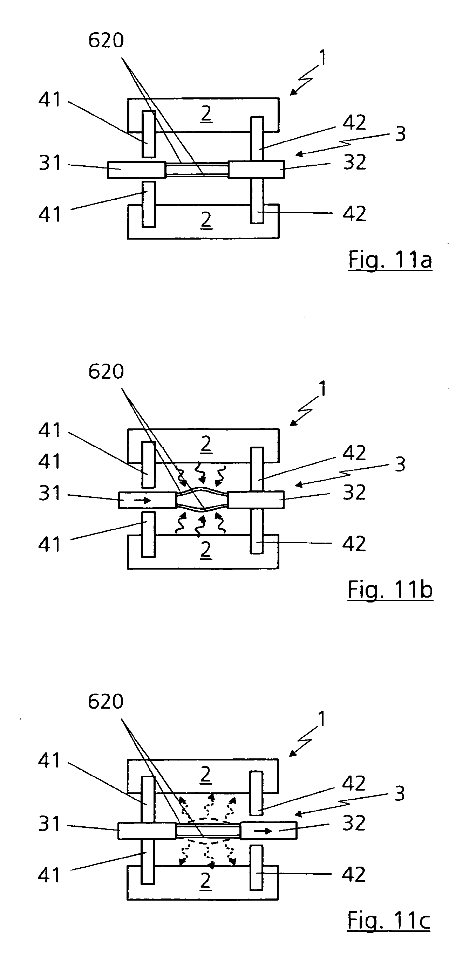

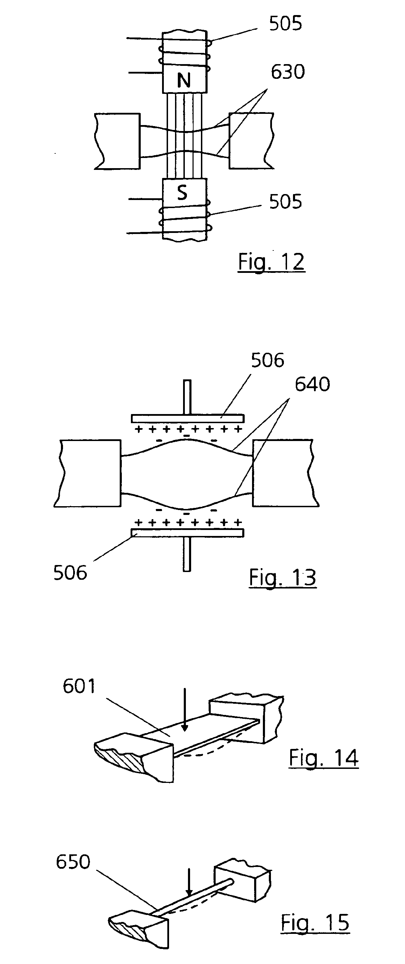

In Figur 11 ist die Möglichkeit eines thermischen Antriebs dargestellt, bei dem die Deformationseinheit 6 als Paar von Bimetallstreifen realisiert ist; die Durchbiegung der Bimetallstreifen 620 erfolgt dabei, wie in den Teilfiguren 11b und 11c dargestellt, durch Wärmezu- bzw. Wärmeabfuhr. Figur 11a zeigt die Anordnung im neutralen zustand. Ebenso lässt sich die Verformungseinheit als Kombination zweier Magnetspulen 505 mit den magnetischen Biegefedern 630 realisieren, wie in Figur 12 dargestellt.

Daneben kann auch ein Kondensator mit den Kondensatorplatten 506 zur Anwendung als Deformator kommen, dessen elektrisches Feld zu einer Deformation der zwischen den Kondensatorplatten 506 angeordneten Biegeelemente 640 führt.

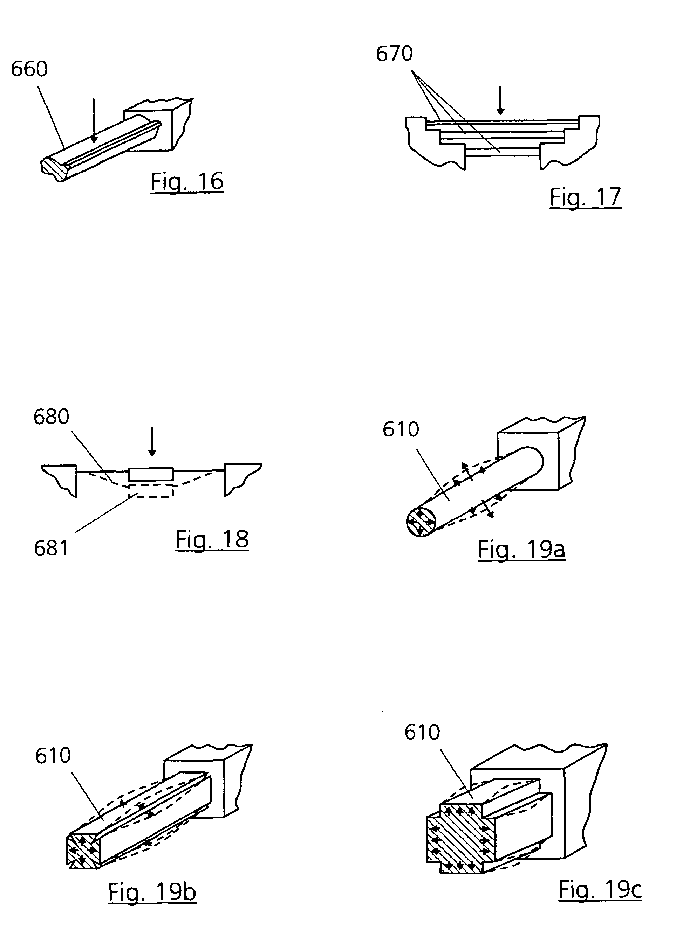

Die Figuren 14 bis 19 zeigen weitere Möglichkeiten, das Deformationselement 6 zu gestalten; in Figur 14 ist die bereits vorgestellte Möglichkeit einer Blattfeder 601 vorgestellt, wohingegen in Figur 15 eine Drahtfeder 650 zur Anwendung kommt. Wie in Figur 16 dargestellt, kann es sich auch um ein Deformationselement 660 mit einem beliebigen Querschnitt handeln. Figur 17 zeigt eine Variante, bei der als Deformationselement eine Kombination aus verschiedenen Biegefedern 670 mit unterschiedlichem Querschnitt und unterschiedlicher Länge verwendet wird, dies ermöglicht eine Anpassung der Aktuator-Wirkung an die jeweils herrschenden Anforderungen des Einsatzes des erfindungsgemäßen Aktuators.

Figur 18 zeigt eine Möglichkeit, bei der die Deformationseinheit in Wirkrichtung des Aktuators mindestens zwei Abschnitte mit unterschiedlichen elastischen Eigenschaften aufweist. Dies wird dadurch realisiert, dass ein massives Zwischenstück 681 in der Biegefeder 680 angeordnet ist. Durch das massive Zwischenstück 681 wird eine definierte Auflagefläche für die in Figur 18 nicht dargestellten Deformatoren geschaffen. Dies führt dazu, dass auch bei einer Seitwärtsbewegung des Läufers über einen begrenzten Bereich definierte Verhältnisse für die Krafteinwirkung der Deformatoren auf das Deformationselement herrschen.

Figur 19 zeigt in den Teilfiguren a, b und c verschiedene Möglichkeiten zur Gestaltung eines dünnwandigen Rohres, das von innen her mit Druck beaufschlagt werden kann, als Deformationselement 610.

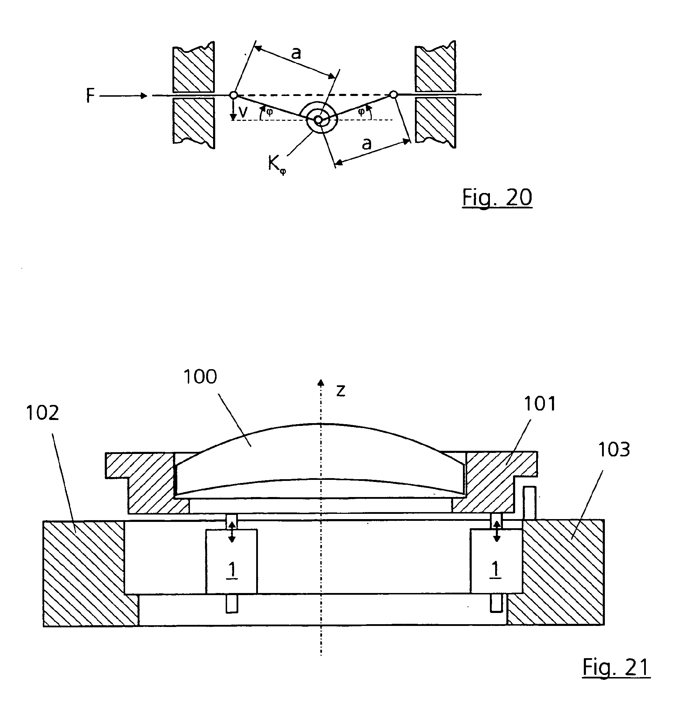

Anhand der Figur 20 kann das Funktionsprinzip der weitgehend lastunabhängigen Läuferschrittweite erklärt werden:

Der Läufer mit Deformationseinheit wird durch ein mechanisches Ersatzmodell nachgebildet, das aus vier Stäben besteht, die mit drei Drehgelenken miteinander verbunden sind, wobei zum mittleren Drehgelenk eine Drehfeder parallel angeordnet ist.

Die inneren Stäbe haben jeweils die Länge a; die Drehfeder hat die Drehfedersteifigkeit $k_\varphi$.

Der Stab rechts außen wird durch eine Arretiereinheit festgehalten, während der Stab links außen (z. b. durch eine geöffnete Arretiereinheit) linear geführt wird.

Das mittlere Drehgelenk ist durch einen Deformator um den Weg v ausgelenkt worden, wodurch die inneren Stäbe den Winkel $\varphi$ zur Horizontalen einnehmen.

Am Stab links außen greift die Kraft F an, und übt auf das mittlere Drehgelenk das Beugemoment $M_{Beug}$ aus, das das mittlere Drehgelenk beugen möchte. Das Beugemoment $M_{Beug}$ ergibt sich aus dem Versatz des Weges v und der Kraft F

$$M_{Beug} = F*v$$

Durch die Länge a der inneren Stäbe hängt der Weg v vom Beugewinkel 2*$\varphi$ des mittleren Drehgelenks ab.

$$v = a*sin[(2*\varphi/2] = a*sin(\varphi)$$

Für kleine Wege v und Winkel $\varphi$ kann näherungsweise eine Linearisierung vorgenommen werden.

$$v = a*\varphi$$

Das Beugemoment $M_{Beug}$ lässt sich damit in Abhängigkeit vom halben Beugewinkel $\varphi$ des mittleren Drehgelenkes darstellen.

$$M_{Beug} = F* a*\varphi$$

Andererseits übt die Drehfeder auf das mittlere Drehgelenk das Streckmoment $M_{Streck}$ aus, das das Drehgelenk und den gesamten Läufer strecken möchte.

Das Streckmoment $M_{Streck}$ ist durch den Beugewinkel 2*$\varphi$ des mittleren Drehgelenkes und der Drehfedersteifigkeit $k_\varphi$ gegeben.

$$M_{Streck} = k_\varphi * 2 * \varphi = 2 * k_\varphi * \varphi$$

Der Läufer streckt sich wieder vollkommen, wenn das Beugemoment $M_{Beug}$ kleiner als das Streckmoment $M_{Streck}$ ist:

$$M_{Beug} < M_{Streck}$$

$$F * a * \varphi < 2 * k_\varphi * \varphi$$

$$F * a < 2 * k_\varphi$$

Für die Kraft F ergibt sich aus der Ungleichung eine Grenze, die die Kraft F nicht übersteigen darf, damit sich der Läufer wieder vollkommen streckt.

Diese Grenze ist die kritische Kraft $F_{krit}$.

$$F < (2 * k_\varphi)/a = F_{krit}$$

Unter der Bedingung, daß die Kraft F kleiner als die kritische Kraft $F_{krit}$ ist und bleibt, wird sich der Läufer wieder vollkommen strecken, so daß, die Schrittweite des Läufers, die sich aus der Streckbewegung des Läufers ergibt, unabhängig von der Kraft F ist.

Erklären läßt sich die Unabhängigkeit der Schrittweite von der Kraft F dadurch, daß das Streckmoment $M_{Streck}$ um die Nullage (Strecklage) des Läufers stärker anwächst als das Beugemoment $M_{Beug}$, wenn die Kraft F kleiner als die kritische Kraft $F_{krit}$ ist.

Für eine reale Blattfeder entspricht die kritische Kraft $F_{krit}$ der Eulerschen Knickkraft im entsprechenden Knicklastfall.

Ergänzend ist anzumerken, dass die Deformationseinheit nicht zwingend elastische Bestandteile haben muss. Es ist ebenso denkbar, dass die Deformation der Deformationseinheit über einen Deformator erfolgt, der sowohl Druck als auch Zug ausüben kann. Hierdurch müsste dann die Deformationseinheit selbst nicht zwingend eine Rückstellkraft aufbringen.

Wegen seiner hohen Steifigkeit, seiner hohen Stellkräfte und seiner weitgehend lastunabhängigen Schrittweite eignet sich der Aktuator für die Einsatzbereiche, in denen bei einer sehr hohen erforderlichen Positionsgenauigkeit eine Positionsmessung des zu justierenden Objektes zur Ansteuerung des Aktuators nur sehr schwer realisierbar ist und oder sehr große Massen positioniert werden müssen.

Diese Anforderungen sind beispielsweise bei den z-Manipulatoren in einem Halbleiterlithographieobjektiv gegeben, die vor Beginn des Betriebes Linsen zur Korrektur von Bildfehlern sehr genau in z-Richtung positionieren und während des Betriebes zeitnah um diese Position die Linsen in z-Richtung fein einstellen, um Bildfehler, die aus den Schwankungen der Betriebsumgebung herrühren, zu korrigieren; ein Beispiel wird in Figur 21 gegeben.

Ein z-Manipulator kann dabei so aufgebaut sein, daß eine Linse 100 in einem Innenring 101 gefaßt ist, der wiederum mit drei Aktuatoren 1 gemäß der Erfindung, deren Wirkrichtung parallel zur z-Richtung orientiert ist, getragen wird.

Die drei Aktuatoren 1 sind in einem Außenring 102 eingebettet, der in seinem Außenbereich die Schnittstelle zur nicht dargestellten Objektivstruktur bildet.

Wegen der hohen Aktuatorsteifigkeit können die Aktuatoren 1 den Innenring 101 samt der Linse 100 direkt in z-Richtung abstützen, ohne daß das System aus Linse 100, Innenring 101 und Aktuatoren 1 zu schwingungsanfällig wird.

Mit dem Sensor für die Mittelstellung 103 kann der Aktuator 1 nach einem Stromausfall wieder ungefähr in die Mittelstellung gestellt werden.

Für die Bildfehlerkorrektur vor dem Betrieb können die Aktuatoren 1 im Schrittmodus in die mittlere z-Position der Linse 100 fahren, wobei ein Sensor, der exakt die z-Position der Linse 100 erfaßt, nicht notwendig ist, da die Schrittweite wegen ihrer weitgehenden Lastunabhängigkeit ziemlich genau definiert ist. Um die gewünschte z-Position zu erreichen, muß aber die Anzahl der ausgeführten Schritte gezählt werden.

Für die Schwankungen um die mittlere z-Position kann der Aktuator 1 im Feinverstellmodus gemäß Fig. 5 genutzt werden.

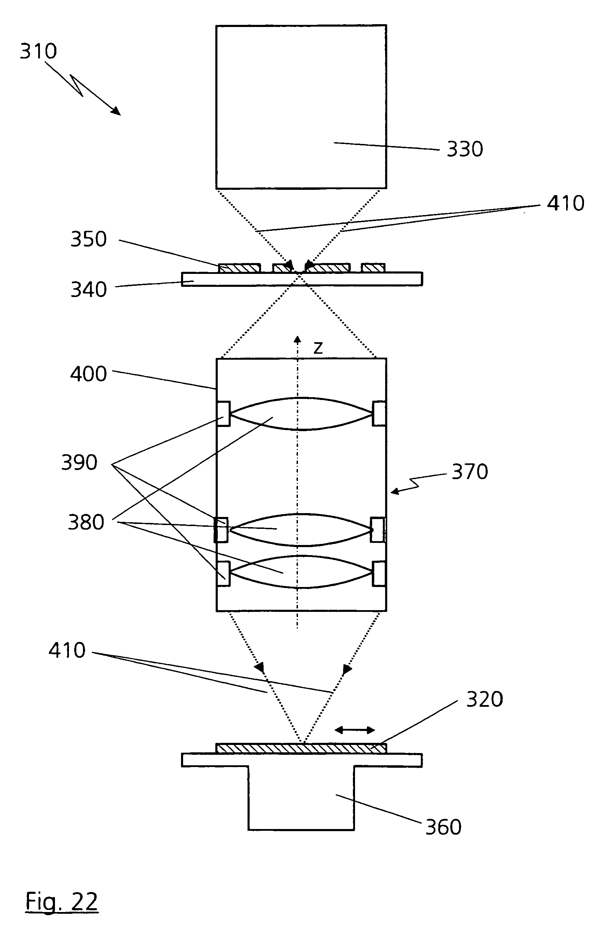

In Figur 22 ist eine Projektionsbelichtungsanlage 310 für die Halbleiterlithographie dargestellt, in welcher der erfindungsgemäße Aktuator zur Anwendung kommt. Die Anlage dient zur Belichtung von Strukturen auf ein mit photosensitiven Materialien beschichtetes Substrat, welches im allgemeinen überwiegend aus Silizium besteht und als Wafer 320 bezeichnet wird, zur Herstellung von Halbleiterbauelementen, wie z.B. Computerchips.

Die Projektionsbelichtungsanlage 310 besteht dabei im wesentlichen aus einem Beleuchtungssystem 330, einer Einrichtung 340 zur Aufnahme und exakten Positionierung einer mit einer Struktur versehenen Maske, eines sogenannten Reticles 350, durch welches die späteren Strukturen auf dem Wafer 320 bestimmt werden, einer Einrichtung 360 zur Halterung, Bewegung und exakten Positionierung eben dieses Wafers 320 und einer Abbildungseinrichtung, nämlich einem Projektionsobjektiv 370, mit mehreren optischen Elementen 380, die über Fassungen 390 in einem Objektivgehäuse 400 des Projektionsobjektives 370 gelagert sind.

Das grundsätzliche Funktionsprinzip sieht dabei vor, dass die in das Reticle 350 eingebrachten Strukturen auf den Wafer 320 abgebildet werden; die Abbildung wird in der Regel verkleinernd ausgeführt.

Nach einer erfolgten Belichtung wird der Wafer 320 in Pfeilrichtung weiterbewegt, sodass auf demselben Wafer 320 eine Vielzahl von einzelnen Feldern, jeweils mit der durch das Reticle 350 vorgegebenen Struktur, belichtet wird. Aufgrund der schrittweisen Vorschubbewegung des Wafers 320 in der Projektionsbelichtungsanlage 310 wird diese häufig auch als Stepper bezeichnet.

Das Beleuchtungssystem 330 stellt einen für die Abbildung des Reticles 350 auf dem Wafer 320 benötigten Projektionsstrahl 410, beispielsweise Licht oder eine ähnliche elektromagnetische Strahlung, bereit. Als Quelle für diese Strahlung kann ein Laser oder dergleichen Verwendung finden. Die Strahlung wird in dem Beleuchtungssystem 330 über optische Elemente so geformt, dass der Projektionsstrahl 410 beim Auftreffen auf das Reticle 350 die gewünschten Eigenschaften hinsichtlich Durchmesser, Polarisation, Form der Wellenfront und dergleichen aufweist.

Über die Strahlen 410 wird ein Bild des Reticles 350 erzeugt und von dem Projektionsobjektiv 370 entsprechend verkleinert auf den Wafer 320 übertragen, wie bereits vorstehend erläutert wurde. Das Projektionsobjektiv 370 weist eine Vielzahl von einzelnen refraktiven, diffraktiven und/oder reflexiven optischen Elementen 380, wie z.B. Linsen, Spiegeln, Prismen, Abschlussplatten und dergleichen auf. Dabei kann eines oder mehrere der optischen Elemente in einem Manipulator in der Art des in der Figur 21 dargestellten Manipulators angeordnet sein.

Die z-Richtung ist in der vorliegenden Darstellung entsprechend der Figur 21 angedeutet.

## Patentansprüche

1. Aktuator (1) mit einer Wirkrichtung, mit einem Gehäuse (2) und einem gegenüber dem Gehäuse (2) in Wirkrichtung des Aktuators (1) bewegbaren Läufer (3), **dadurch gekennzeichnet, dass** der Aktuator (1) eine Vorschubeinheit aufweist, die mindestens zeitweise mit dem Läufer (3) in Verbindung steht und wobei die Vorschubeinheit mindestens eine Deformationseinheit (6,601,610,620,630,640,650,660,670,680) sowie mindestens einen Deformator (5,501,502,503,504,505,506) zur Verformung der Deformationseinheit (6, 601, 610, 620, 630, 640, 650, 660, 670, 680) aufweist, wobei der mindestens eine Deformator (5,501,502,503,504,505,506) geeignet ist, die Deformationseinheit (6,601,610,620,630,640,650,660,670,680) mit einer zur Wirkrichtung des Aktuators (1) senkrechten Vektorkomponente derart zu verformen, dass sich die Gesamtlänge der Deformationseinheit (6,601,610,620,630,640,650,660,670,680) in Wirkrichtung als Ergebnis der Verformung ändert.

2. Aktuator (1) nach Anspruch 1, **dadurch gekennzeichnet, dass** das Gehäuse (2) aus mindestens zwei Gehäuseteilen (21,22) besteht, die über die Deformationseinheit (s. o.) miteinander verbunden sind.

3. Aktuator (1) nach Anspruch 2, **dadurch gekennzeichnet, dass** die mindestens zwei Gehäuseteile (21,22) jeweils mindestens eine Arretiereinheit (41,42) aufweisen, mit welcher der Läufer an dem jeweiligen Gehäuseteil (21,22) arretiert werden kann.

4. Aktuator (1) nach Anspruch 3, **dadurch gekennzeichnet, dass** die Deformationseinheit (6) mindestens eine Blattfeder (601) aufweist.

5. Aktuator (1) nach Anspruch 3, **dadurch gekennzeichnet, dass** die Deformationseinheit (6) als Federpaar aus zwei einander gegenüberliegenden Blattfedern (601) ausgebildet ist und dass mindestens zwei Deformatoren (5) derart an dem Federpaar angeordnet sind, dass sie von außen her die Blattfedern (601) auf einander zu biegen können.

6. Aktuator (1) nach Anspruch 1, **dadurch gekennzeichnet, dass** der Läufer (3) einen ersten und einen zweiten Teilläufer (31,32) aufweist, die über die als Teil des Läufers (3) ausgebildete Deformationseinheit (6) verbunden sind.

7. Aktuator (1) nach Anspruch 6, **dadurch gekennzeichnet, dass** mindestens zwei Arretiereinheiten (41,42) vorhanden sind, die jeweils einen der Teilläufer (31,32) gegenüber dem Gehäuse (21,22) arretieren können.

8. Aktuator (1) nach einem der vorangehenden Ansprüche, **dadurch gekennzeichnet, dass** der Aktuator (1) Dämpfungselemente (7) zur Hemmung der Bewegung des Läufers (3) in Wirkrichtung des Aktuators (1) aufweist.

9. Aktuator (1) nach einem der vorangehenden Ansprüche, **dadurch gekennzeichnet, dass** die Deformationseinheit (6) mindestens ein druckbeaufschlagbares Rohr (601) aufweist.

10. Aktuator (1) nach einem der vorangehenden Ansprüche 1 bis 9, **dadurch gekennzeichnet, dass** die Deformationseinheit (6) mindestens ein temperierbares Bimetall (620) aufweist.

11. Aktuator (1) nach einem der vorangehenden Ansprüche 1 bis 9, **dadurch gekennzeichnet, dass** die Deformationseinheit (6) mindestens eine magnetische Biegefeder (630) aufweist.

12. Aktuator (1) nach einem der vorangehenden Ansprüche 1 bis 9, **dadurch gekennzeichnet, dass** die Deformationseinheit (6) mindestens eine Drahtfeder (650) aufweist.

13. Aktuator (1) nach einem der vorangehenden Ansprüche 1 bis 9, **dadurch gekennzeichnet, dass** die Deformationseinheit (6) eine Kombination unterschiedlicher Biegefedern (670) mit unterschiedlichem Querschnitt und/oder unterschiedlicher Länge aufweist.

14. Aktuator (1) nach einem der vorangehenden Ansprüche, **dadurch gekennzeichnet, dass** die Deformationseinheit (6) in Wirkrichtung des Aktuators (1) mindestens zwei Abschnitte (680,681) mit unterschiedlichen elastischen Eigenschaften aufweist.

15. Aktuator (1) nach einem der vorangehenden Ansprüche, **dadurch gekennzeichnet, dass** der Deformator (5) ein Piezoelement, insbesondere einen Piezostack (810), aufweist.

16. Aktuator (1) nach einem der vorangehenden Ansprüche, **dadurch gekennzeichnet, dass** der Deformator (5) eine elektromagnetische Spule (502) aufweist.

17. Aktuator (1) nach einem der vorangehenden Ansprüche, **dadurch gekennzeichnet, dass** der Deformator (5) einen Hydraulik- oder Pneumatikzylinder (503) aufweist.

18. Aktuator (1) nach einem der vorangehenden Ansprüche, **dadurch gekennzeichnet, dass** der Deformator (5) einen pneumatischen Balg (504) aufweist.

19. Aktuator (1) nach einem der vorangehenden Ansprüche, **dadurch gekennzeichnet, dass** der Deformator (5) als Kondensator mit Kondensatorplatten (506) ausgebildet ist, dessen elektrisches Feld zu einer Deformation von zwischen den Kondensatorplatten (506) angeordneten Biegeelementen (640) führt.

20. Projektionsbelichtungsanlage (310) für die Halbleiterlithographie mit einem Aktuator (1) nach einem der vorangehenden Ansprüche, zur Bewegung eines optischen Elements (100) der Projektionsbelichtungsanlage (310) in Richtung der optischen Achse der Projektionsbelichtungsanlage (310) bzw. eines Teils der Projektionsbelichtungsanlage (310).

21. Projektionsbelichtungsanlage (310) nach Anspruch 20, **dadurch gekennzeichnet, dass** des optische Element (100) ausschließlich über die Aktuatoren (1) mit weiteren Komponenten der Projektionsbelichtungsanlage (310) in Verbindung steht.

**22.** Verfahren zum Betrieb eines Aktuators (1) mit einer Wirkrichtung, einem Gehäuse (2) und einem gegenüber dem Gehäuse (2) in Wirkrichtung des Aktuators (1) bewegbaren Läufer (3), wobei der Läufer (3) eine Deformationseinheit (6) aufweist und durch die nachfolgenden Schritte bewegt wird

- Fixieren des Läufers (3) durch eine in Bewegungsrichtung des Läufers gesehen vor der Deformationseinheit (6) befindliche erste Arretiereinheit (41)
- Lösen einer in Bewegungsrichtung des Läufers (3) gesehen hinter der Deformationseinheit befindliche zweiten Arretiereinheit (42) von dem Läufer (3)
- Deformation der Deformationseinheit (6) durch einen Deformator
- Fixierung des Läufers durch die zweite Arretiereinheit (42)
- Lösen der ersten Arretiereinheit (41)
- Lösen des Deformators (5) von der Deformationseinheit (6)

## Claims

**1.** An actuator (1) having an effective direction, having a housing (2) and a movable part (3) that can be moved in relation to the housing (2) in the effective direction of the actuator (1), **characterized in that** the actuator (1) has an advancing unit that is at least temporarily connected to the movable part (3), and the advancing unit having at least one deformation unit (6, 601, 610, 620, 630, 640, 650, 660, 670, 680) and at least one deformer (5, 501, 502, 503, 504, 505, 506) for reforming the deformation unit (6, 601, 610, 620, 630, 640, 650, 660, 670, 680), the at least one deformer (5, 501, 502, 503, 504, 505, 506) being suited to deform the deformation unit (6, 601, 610, 620, 630, 640, 650, 660, 670, 680) with a vector component perpendicular to the effective direction of the actuator (1) in such a way that the total length of the reformation unit (6, 601, 610, 620, 630, 640, 650, 660, 670, 680) changes in the effective direction as a result of the deformation.

**2.** The actuator (1) as claimed in claim 1, **characterized in that** the housing (2) consists of at least two housing parts (21, 22) that can be interconnected via the deformation unit (see above).

**3.** The actuator (1) as claimed in claim 2, **characterized in that** the at least two housing parts (21, 22) respectively have at least one locking unit (41, 42) with the aid of which the movable part can be locked on the respective housing part (21, 22).

**4.** The actuator (1) as claimed in claim 3, **characterized in that** the deformation unit (6) has at least one leaf spring (601).

**5.** The actuator (1) as claimed in claim 3, **characterized in that** the deformation unit (6) is designed as a pair of springs composed of two opposing leaf springs (601), and **in that** at least two deformers (5) are arranged on the pair of springs in such a way that they can bend the leaf springs (601) toward one another from outside.

**6.** The actuator (1) as claimed in claim 1, **characterized in that** the movable part (3) has a first and a second partial movable part (31, 32) that are connected via the deformation unit (6) designed as part of the movable part (3).

**7.** The actuator (1) as claimed in claim 6, **characterized in that** at least two locking units (41, 42) that can respectively lock one of the partial movable parts (31, 32) in relation to the housing (21, 22) are present.

**8.** The actuator (1) as claimed in one of the preceding claims, **characterized in that** the actuator (1) has damping elements (7) for inhibiting the movement of the movable part (3) in the effective direction of the actuator (1).

**9.** The actuator (1) as claimed in one of the preceding claims, **characterised in that** the deformation unit (6) has at least one pressurizable tube (601).

**10.** The actuator (1) as claimed in one of the preceding claims 1 to 9, **characterized in that** the deformation unit (6) has at least one temperature-controllable bimetal (620).

**11.** The actuator (1) as claimed in one of the preceding claims 1 to 9, **characterized in that** the deformation unit (6) has at least one magnetic spiral spring (630).

**12.** The actuator (1) as claimed in one of the preceding claims 1 to 9, **characterized in that** the deformation unit (6) has at least one wire spring (650).

13. The actuator (1) as claimed in one of the preceding claims 1 to 9, **characterized in that** the deformation unit (6) has a combination of different spiral springs (670) of different cross section and/or different length.

14. The actuator (1) as claimed in one of the preceding claims, **characterized in that** the deformation unit (6) has at least two sections (680, 681) with different elastic properties in the effective direction of the actuator (1).

15. The actuator (1) as claimed in one of the preceding claims, **characterized in that** the deformer (5) has a piezo element, in particular a piezo stack (810).

16. The actuator (1) as claimed in one of the preceding claims, **characterized in that** the deformer (5) has an electromagnetic coil (502).

17. The actuator (1) as claimed in one of the preceding claims, **characterized in that** the deformer (5) has a hydraulic or pneumatic cylinder (503).

18. The actuator (1) as claimed in one of the preceding claims, **characterized in that** the deformer (5) has a pneumatic bellows (504).

19. The actuator (1) as claimed in one of the preceding claims, **characterized in that** the deformer (5) is designed as a capacitor with capacitor plates (506) whose electric field leads to a deformation of bending elements (640) arranged between the capacitor plates (506).

20. A protection exposure system (110) for semiconductor lithography, having an actuator (1) as claimed in one of the preceding claims, for the purpose of moving an optical element (100) of the protection exposure system (310) in the direction of the optical axis of the protection exposure system (310) or of a part of the projection exposure system (310).

21. The protection exposure system (310) as claimed in claim 20, **characterized in that** the optical element (100) is connected to further components of the projection exposure system (310) exclusively via the actuators (1).

22. The method for operating an actuator (1) having an effective direction, a housing (2) and a movable part (3) that can be moved in relation to the housing (2) in the effective direction of the actuator (1), the movable part (3) having a deformation unit (6) and is moved by the following steps

- fixing the movable part (3) by a first locking unit (41) located upstream of the deformation unit (6) seen in the direction of movement of the movable part,
- releasing a second locking unit (42) of the movable part (3) that is located downstream of the deformation unit seen in the direction of movement of the movable part (3),
- deforming the deformation unit (6) by a deformer,
- fixing the movable part by the second locking unit (42),
- releasing the first locking unit (41), and
- releasing the deformed (5) from the deformation unit (6).

**Revendications**

1. Actionneur (1) ayant une direction opératoire, comportant un boîtier (2) ainsi qu'un curseur (3) mobile disposé à l'opposé du boîtier (2) dans la direction de l'actionneur (1), **caractérisé en ce que** l'actionneur (1) comprend une unité de poussée qui est au moins momentanément en liaison avec le curseur (3) et dans lequel l'unité de poussée comprend au moins une unité de déformation (6, 601, 610, 620, 630, 640, 650, 660, 670, 680) ainsi qu'au moins un déformateur (5, 501, 502, 503, 504, 505, 506) en vue de la déformation de l'unité de déformation (6, 601, 610, 620, 630, 640, 650, 660, 670, 680), dans lequel ledit au moins un déformateur (5, 501, 502, 503, 504, 505, 506) est agencé pour déformer l'unité de déformation (6, 601, 610, 620, 630, 640, 650, 660, 670, 680) selon une composante vectorielle perpendiculaire à la direction opératoire de l'actionneur (1) de telle manière que la longueur totale de l'unité de déformation (6, 601, 610, 620, 630, 640, 650, 660, 670, 680) varie dans la direction opératoire comme une conséquence de la déformation.

**2.** Actionneur (1) selon la revendication 1, **caractérisé en ce que** le boîtier (2) est constitué d'au moins deux éléments de boîtier (21, 22) qui sont couplés par l'unité de déformation (voir ci-dessus).

**3.** Actionneur (1) selon la revendication 2, **caractérisé en ce que** lesdits au moins deux éléments (21, 22) comportent respectivement une unité d'arrêt (41, 42), au moyen de laquelle le curseur peut être arrêté contre les éléments de boîtier (21, 22) respectifs.

**4.** Actionneur (1) selon la revendication 3, **caractérisé en ce que** l'unité de déformation (6) comporte au moins un ressort plat (601).

**5.** Actionneur (1) selon la revendication 3, **caractérisé en ce que** l'unité de déformation (6) est constituée d'une paire de ressorts composée d'un couple de ressorts plats (601) placés en regard l'un par rapport à l'autre et **en ce que** au moins deux déformateurs (5) sont disposés contre le couple de ressorts, de telle manière qu'ils sont susceptibles de plier depuis l'extérieur les ressorts plats (601) sur l'autre.

**6.** Actionneur (1) selon la revendication 1, **caractérisé en ce que** le curseur (3) comprend un premier et un second curseur partiel (31, 32) qui sont reliés par l'unité de déformation (6) qui est conformée en partie de curseur (3).

**7.** Actionner (1) selon la revendication 6, **caractérisé en ce qu'**il comporte au moins deux unités d'arrêt (41, 42) agencés pour arrêter respectivement un des curseurs partiels (31, 32) par rapport au boîtier (21, 22).

**8.** Actionneur (1) selon l'une des revendications précédentes, **caractérisé en ce que** l'actionneur (1) comporte des éléments amortisseurs (7) pour amortir le mouvement du curseur (3) dans la direction opératoire de l'actionneur (1).

**9.** Actionneur (1) selon l'une des revendications précédentes, **caractérisé en ce que** l'unité de déformation (6) comporte au moins un tube (601) conçu pour être soumis à pression.

**10.** Actionneur (1) selon l'une des revendications précédentes 1 à 9, **caractérisé en ce que** l'unité de déformation (6) comporte au moins un bimétal pouvant être équilibré en température (620).

**11.** Actionneur (1) selon l'une des revendications précédentes 1 à 9, **caractérise en ce que** l'unité de déformation (6) comporte au moins un ressort de flexion magnétique (630).

**12.** Actionneur (1) selon l'une des revendications précédentes 1 à 9, **caractérisé en ce que** l'unité de déformation (6) comporte au moins un ressort à fil (650).

**13.** Actionneur (1) selon l'une des revendications précédentes 1 à 9, **caractérisé en ce que** l'unité de déformation (6) comporte une combinaison de différents ressorts de flexion (670) ayant des sections différentes et/ou des longueurs différentes.

**14.** Actionneur (1) selon l'une des revendications précédentes, **caractérisé en ce que** l'unité de déformation (6) comporte, dans la direction opératoire de l'actionneur (1) au moins deux tronçons (680, 681) ayant des caractéristiques élastiques différentes.

**15.** Actionner (1) selon l'une des revendications précédentes, **caractérisé en ce que** le déformateur (5) comporte un élément piézoélectrique, en particulier un bloc piézoélectrique (810).

**16.** Actionner (1) selon l'une des revendications précédentes, **caractérisé en ce que** le déformateur (5) comporte une bobine électromagnétique (502).

**17.** Actionneur (1) selon l'une des revendications précédentes, **caractérisé en ce que** le déformateur (5) comporte un vérin pneumatique ou hydraulique (503).

**18.** Actionneur (1) selon l'une des revendications précédentes, **caractérisé en ce que** le déformateur (5) comporte un soufflet pneumatique (504).

**19.** Actionneur (1) selon l'une des revendications précédentes, **caractérisé en ce que** le déformateur (5) est configuré sous la forme d'un condensateur avec des plaques de condensateur (506) dont le champ électrique engendre une déformation d'éléments de flexion (640) disposés entre les plaques de condensateur (506).

20. Installation d'éclairage par projection (310) pour la lithographie de semiconducteurs, comportant un actionneur (1) selon l'une des revendications précédentes, pour le déplacement d'un élément optique (100) de l'installation d'éclairage par projection (310), dans la direction de l'axe optique de l'installation d'éclairage par projection (310), respectivement d'une partie de l'installation d'éclairage par projection (310).

21. Installation d'éclairage par projection (310) selon la revendication 20, **caractérisé en ce que** l'élément optique (100) est en liaison avec d'autres composants de l'installation d'éclairage par projection (310), exclusivement au moyen de l'actionneur (1).

22. Procédé de fonctionnement de l'actionneur (1) ayant une direction opératoire, comportant un boîtier (2) ainsi qu'un curseur (3) mobile à l'opposé du boîtier (2) dans la direction opératoire de l'actionneur (1), dans lequel le curseur (3) comporte une unité de déformation (6) et qui est actionnée selon les étapes de procédé suivantes :

- la fixation du curseur (3) au moyen d'une première unité d'arrêt (41) se trouvant devant l'unité de déformation (6), vue dans la direction de déplacement du curseur,
- la libération d'une seconde unité d'arrêt (42) du curseur (3) se trouvant derrière l'unité de déformation, vue dans la direction de déplacement du curseur (3),
- la déformation de l'unité de déformation (6) au moyen d'un déformateur,
- la fixation du curseur par la seconde unité d'arrêt (42),
- la libération de la première unité d'arrêt (41),
- la libération du déformateur (5) de l'unité déformation (6).

Fig. 1a

Fig. 1b

Fig. 1c

Fig. 1d

Fig. 2a

Fig. 2b

Fig. 2c

Fig. 2d

Fig. 3

Fig. 4a

Fig. 4b

Fig. 4c

Fig. 4d

Fig. 4e

Fig. 5

Fig. 6

Fig. 7

503

601

Fig. 8

601

601     504     Fig. 9

610

Fig. 10

Fig. 11a

Fig. 11b

Fig. 11c

EP 2 300 877 B1

505

630

N

630

S

505

Fig. 12

506

640

+ + + + + + + +
- -
- -
+ + + + + + + +

506

Fig. 13

601

Fig. 14

650

Fig. 15

Fig. 16

Fig. 17

Fig. 18

Fig. 19a

Fig. 19b

Fig. 19c

Fig. 20

Fig. 21

Fig. 22

**IN DER BESCHREIBUNG AUFGEFÜHRTE DOKUMENTE**

**In der Beschreibung aufgeführte Patentdokumente**

- DE 10225266 A1
- DE 1933205 A